# EUROPÄISCHE PATENTSCHRIFT

(11) **EP 2 193 551 B1**
(45) Veröffentlichungstag und Bekanntmachung des Hinweises auf die Patenterteilung: **03.06.2015**
(21) Anmeldenummer: 08801317.2
(22) Anmeldetag: 09.09.2008
(51) Int. Cl.: H01L 33/62, H01L 25/075, H01L 25/16

(54) **ANORDNUNG UMFASSEND EIN OPTOELEKTRONISCHES BAUELEMENT**
ARRANGEMENT COMPRISING AN OPTOELECTRONIC COMPONENT
ENSEMBLE COMPRENANT UN COMPOSANT OPTOÉLECTRONIQUE

(30) Priorität: 28.09.2007 DE 102007046720; 12.11.2007 DE 102007053849
(43) Veröffentlichungstag der Anmeldung: 09.06.2010
(73) Patentinhaber: Osram Opto Semiconductors Gmbh, 93055 Regensburg (DE)
(72) Erfinder: EISSLER, Dieter, 93152 Nittendorf / Etterzhausen (DE)
(74) Vertreter: Epping - Hermann - Fischer
(86) Internationale Anmeldenummer: PCT/DE2008/001513
(87) Internationale Veröffentlichungsnummer: WO 2009/039825

(56) Entgegenhaltungen:
- EP-A- 0 631 461
- EP-A- 1 398 839
- EP-A- 1 469 516
- WO-A-2004/105142
- WO-A-2005/067063
- JP-A- 6 120 225
- JP-A- 2008 066 454
- US-A1- 2006 118 800

## Beschreibung

Die Erfindung betrifft eine Anordnung umfassend ein optoelektronisches Bauelement mit zwei Kontakten und wenigstens einem weiteren Bauteil, wobei zumindest ein Kontakt zwischen dem optoelektronischen Bauelement und dem weiteren Bauteil angeordnet ist.

Die Kontaktierung zwischen einem optoelektronischen Bauelement mit einem weiteren Bauteil erfolgt üblicherweise über Bondverbindung mit so genannten Wirebonds, das heißt es wird eine Drahtverbindung zwischen dem optoelektronischen Bauelement und dem weiteren Bauteil hergestellt.

Bei Kontakten direkt zwischen dem optoelektronischen Bauelement und dem weiteren Bauteil ist es auch möglich, so genannte Studbumps, das heißt Lotreservoire entweder an den Kontakten des optoelektronischen Bauelements oder des weiteren Bauteils anzuformen und diese bei Montage über Ultraschall oder Warmverlöten oder eine Kombination von beiden zu verschweißen.

Eine weitere Möglichkeit ist auch die Verklebung der Kontakte mit leitfähigem Kleber. Ebenso ist es auch bekannt, die Kontakte durch Lötverbindungen auf Basis der Solder Bump-Technik mit Lötstopplacken oder geeignet strukturierten Folien herzustellen.

Bei sämtlichen bisher bekannten Techniken zur Kontaktierung eines elektronischen Bauelements mit einem weiteren Bauteil entstehen insbesondere bei der Massenfertigung immer noch Probleme, eine optimale Kontaktierung mit möglichst geringem Ausschuss zu erzielen.

Aus der Druckschrift WO 2004/105142 A1 ist ein Licht emittierendes Bauteil bekannt, bei dem ein LED-Chip mittels Stegen an einem Träger befestigt ist.

Der Erfindung liegt daher die Aufgabe zugrunde, eine Lösung aufzuzeigen, durch welche die Kontaktierung zwischen einem elektronischen Bauelement und einem weiteren Bauteil zuverlässig erzielbar ist und gleichzeitig eine Justage des elektronischen Bauelements und des weiteren Bauteils zueinander erzielt wird.

Erfindungsgemäß wird diese Aufgabe durch einer Anordnung gemäß Anspruch 1 durch gelöst.

Durch den Steg wird eine definierte Montageposition bei der Montage des optoelektronischen Bauelementes auf dem weiteren Bauteil erzielt. Hierdurch wird es möglich, dass auch in einer Massenproduktion das optoelektronische Bauelement und das weitere Bauteil immer so zueinander positioniert sind, dass die gewünschte optimale Kontaktierung erreicht wird.

In einer weiteren Ausgestaltung ist der Steg unmittelbar neben dem Kontakt angeordnet und überbrückt den gesamten Bereich neben dem Kontakt zwischen dem optoelektronischen Bauelement und dem weiteren Bauteil.

Der Steg dient somit nicht nur zur definierten Montageposition, sondern auch zum Höhenausgleich neben dem vorspringenden Kontakt am optoelektronischen Bauelement.

Durch die Überbrückung des gesamten Bereiches neben der Kontaktflächen zwischen dem optoelektronischen Bauelement und dem weiteren Bauteil wird auch eine wesentlich bessere Wärmeleitung zwischen dem optoelektronischen Bauelement und dem weiteren Bauteil erzielt wird.

Gemäß einer Weiterbildung der Erfindung sind beide Kontakte zwischen dem optoelektronischen Bauelement und dem weiteren Bauteil angeordnet und der Steg zwischen den Kontakten des optoelektronischen Bauelementes positioniert.

Diese Art der Ankopplung eignet sich insbesondere für die Ankopplung eines Flipchip-Bauelementes, wie zum Beispiel einer monolithischen Diode in CSP-Ausbildung (CSP = chip scale package), bei welcher mindestens zwei Kontakte auf einer Seite angeordnet sind.

Die Anordnung eines Steges zwischen zwei Kontakten hat neben den Vorteilen der genauen Definition der Montageposition sowie der erhöhten Wärmeleitung die weitere Funktion, dass der Steg auch zur Kurzschlussvermeidung dient.

Durch den Steg zwischen den beiden Kontakten wird vermieden, dass bei der Kontaktierung das Lot oder der Kleber oder Spritzer des Lotes oder des Klebers zur anderen Kontaktfläche fließen und somit Kurzschlussverbindungen bereits beim Aufbau verhindert werden.

Ebenso wird auch die Zeitfestigkeit der Verbindung erhöht, da ein schädliches Materialkriechen der isolierten Kontaktverbindungen unterbunden wird. Insbesondere im Langzeitbetrieb, bei Gleichstromanwendungen unter Einfluss von negativen Umweltbedingungen ist ein schädliches Materialkriechen nicht auszuschließen, was durch den erfindungsgemäßen Steg zwischen den Kontakten unterdrückt wird.

Der Steg kann an dem optoelektronischen Bauelement, an dem weiteren Bauteil oder auch kombiniert am optoelektronischen Bauelement und dem weiteren Bauteil ausgebildet sein.

Zwischen dem optoelektronischen Bauelement und dem weiteren Bauteil können auch mehrere Stege angeordnet sein, die teilweise am optoelektronischen Bauelement und teilweise am weiteren Bauteil festgelegt sind.

Das weitere Bauteil kann ein so genanntes Submount sein, auf welchem das optoelektronische Bauelement kontaktiert wird oder auch ein weiteres optoelektronisches Bauelement.

In einer weiteren Ausführungsform kann der Steg zwischen den Kontakten am optoelektronischen Bauelement angeordnet sein und das optoeletronische Bauelement so auf einem weiteren Träger montiert sein, dass die Kontakte weg von dem weiteren Träger zeigen. Die Kontalkte sind bei dieser Ausführungsform z.B. über Drahtverbindungen, sog. Wirebonds kontaktiert.

Insbesondere beim Übereinanderstapeln von optoelektronischen Bauelementen, kommt die erhöhte Wärmeabführung durch den Steg zum Tragen. Bei einem optoelektronischen Bauelement, z.B. bei Powerdioden werden zwischen 1 und 5 Watt und bei optoelektronischen Modulen sogar mehr als 10 Watt Verlustleistung erzeugt. Beim Übereinanderstapeln von optoelektronischen Bauelementen tritt eine Ballung der Wärmequellen auf und somit ist das Abführen der Verlustwärme ein zentraler Aspekt bei der Realisierung. Wird die Verlustwärme nicht abgeführt, sinkt die Lebensdauer der optoelektronischen Bauelemente drastisch.

Gemäß der Erfindung ist der Steg so ausgebildet, dass bei der Montage eine Selbstjustage des optoelektronischen Bauelementes zu dem weiteren Bauteil erfolgt.

Hierzu sind am Steg sowie am Kontakt oder den Kontakten Einführschrägen ausgebildet, sodass beim Zusammenführen des optoelektronischen Bauelementes mit dem weiteren Bauelement die Einführschräge oder die Einführschrägen so in Wirkung treten, dass eine genaue Justierung der Lage zwischen optoelektronischen Bauelement und dem weiteren Bauteil erzielt wird.

Diese Art der Selbstjustage führt zu einer starken Vereinfachung der Kontaktierung zwischen optoelektronischem Bauelement und weiterem Bauteil.

Insbesondere von Vorteil ist die Selbstjustage beim Diebonding und dadurch sind auch so genannte Folien-Diebonds im Verbund möglich, bei welcher eine Vielzahl von optoelektronischen Bauelementen, welche über eine Folie miteinander verbunden werden, gleichzeitig oder in bestimmten Taktschritten mit den weiteren Bauteilen kontaktiert werden können. Es ergibt sich somit die Ausführbarkeit denkbar kleinster elektronischer Bauelemente mit Selbstjustagemechanismus.

Neben der Selbstjustage ist der Steg vorzugsweise elektrisch isolierend und gut Wärme leitend ausgebildet, sodass neben der Selbstjustage auch die Kurzschlussvermeidung und durch die gesteigerte Wärmeabfuhr auch eine Vermeidung von Hot Spots erzielt wird.

Gemäß einer Weiterbildung der Erfindung sind die Bereiche zwischen dem optoelektronischen Bauelement und dem weiteren Bauteil, welche nicht für eine elektrische Kontaktierung verwendet werden, das heißt nicht geklebt, nicht verlötet oder nicht geschweißt sind, zumindest teilweise aufgeraut.

Durch das teilweise Aufrauen entsteht ein direkter mechanischer Kontakt, wodurch die Wärmeleitung gesteigert wird. Dieser kann durch Zugabe von Füllmaterial oder Wärmeleitpasten unterstützt werden.

Vorzugsweise wird das Füllmaterial oder die Wärmeleitpaste stirnseitig auf die Stege, das heißt an den Bereichen des Steges, auf welchen das optoelektronische Bauelement bei der Montage gedrückt wird, aufgetragen, um gleichzeitig als Toleranzausgleich zu dienen. Hierzu ist es günstig, wenn das Füllmaterial oder die Wärmeleitpaste zumindest geringfügig elastische Eigenschaften aufweist.

Insbesondere bei der Ausgestaltung des optoelektronischen Bauelements als substratloses Flipchip-Bauelement ist der Wärmeübergang vom Bauelement in das Substrat, das heißt dem weiteren Bauteil, kritisch. Durch den aufgerauten Kontakt sowie das Füllmaterial und die Wärmeleitpaste wird der Wärmeübergang vom Bauelement in das Substrat optimiert, sodass ein thermischer Ausfall durch lokal zu hohen Wärmewiderstand in dem Isolationsbereich zwischen den beiden Kontakten weit hinausgezögert oder ganz vermieden wird. Durch die gesteigerte Wärmeleitfähigkeit über die Anordnung des Steges sind somit Bauelemente der höchsten Leistungsklasse realisierbar und dem zusätzlichen Vorteil, dass die empfindlichen und teuren Bonddrähte ebenso entfallen können.

Gemäß einer bevorzugten Ausbildung ist der Steg extrem hoch schmelzend, nicht benetzend und mit spezieller Oberflächengeometrie und Umrandung ausgeführt.

Eine weitere Ausführungsform sieht vor, dass durch den Steg Spitzen und Kanten in der Anordnung möglichst vermieden werden, um die ESD-Festigkeit (ESD = electrostatical discharge) zu steigern. Des Weiteren ist es günstig, die Seiten des Steges oder auch die Stirnfläche gewellt auszugestalten. Durch eine wellige Ausgestaltung der Seiten des Steges oder auch der Stirnfläche wird insbesondere ein Kriechen von Lotmaterialien erheblich erschwert. Die wellige Ausbildung lässt sich vorteilhafterweise durch das Ausnutzen von stehenden Wellen beim Aushärten von vertikalen Fotolackstrukturen ausbilden.

Die wellige Ausbildung ist ebenso am weiteren Bauteil, in der Regel dem Submount, in den nicht kontaktierenden Bereichen vorteilhaft.

Der Steg ist günstigerweise aus einem der folgenden Materialien oder eine Kombination der folgenden Materialien hergestellt: Molybdän, Tantal, Aluminium, Aluminiumnitrit, Kupfer, Legierungen, Titannitrit passiviert, Wolframnitrit und Titan-Wolframnitrit, Gold, Silber, passivierte elektrische Leiter, Dielektrika, Diamant, diamantartige Stoffe, Kunststoffe oder elektrisch isolierendes transparentes Material.

Je nach beabsichtigtem Hauptmerkmal kann das eine oder das andere Material von Vorteil sein. Mehrfachkombination der vorgenannten Materialien, um die kritische Wärmeausdehnung abzufangen, können ebenso sinnvoll sein.

Die Ausbildung der Stege als transparentes Material hat den Vorteil, dass durch die nicht notwendigerweise verbindenden Stege bei Halbleiterleuchtmitteln oder derartige Detektoren sich ein transparenter, das heißt durchsichtiger Stapel, aufbauen lässt.

Gemäß einer Weiterbildung der Erfindung besteht im montierten Zustand zwischen dem optoelektronischen Bauelement und dem weiteren Bauteil ein freier Bereich ohne direkten Kontakt.

Zur thermischen Anpassung kann es im Einzelfall günstig sein, sehr kleine, zur Wärmeverteilung unkritische Bereiche freizulassen und mit einem elastischen Material zu füllen, sodass Risse oder andere durch mechanischen Stress bedingte ungewünschte Eigenschaften zuverlässig unterdrückt werden. Die freien Bereiche zwischen dem optoelektronischen Bauelement und dem weiteren Bauteil verleihen der gesamten Anordnung eine gewisse Elastizität, wodurch die Gefahr, aufgrund mechanischer Einwirkung beschädigt zu werden, reduziert wird.

Eine weitere Weiterbildung sieht vor, dass zwei oder mehrere optoelektronische Bauelemente übereinander gestapelt sind. Die optoelektronischen Bauelemente können dabei deckungsgleich oder auch größenmäßig unterschiedlich ausgestaltet sein.

Bei dieser Ausführungsform werden die optoelektronischen Bauelemente vorteilhafterweise durch so genannte Vias, das heißt Durchgangsbohrungen, welche mit Kontaktmaterial gefüllt sind, miteinander kontaktiert.

Durch diese übereinander gestapelten optoelektronischen Bauelemente lassen sich zum Beispiel Rot-, Grün-, Blaumodule herstellen, die durcheinander oder aneinander vorbei strahlen. Dabei lässt sich die Farbe im Fernfeld optimal einstellen.

Eine weitere Weiterbildung der Erfindung sieht vor, dass der Steg unsymmetrisch ausgeführt ist.

Hierdurch wird eine so genannte Codierung erzielt, sodass das optoelektronische Bauelement nicht falsch auf das weitere Bauteil montiert werden kann und somit die Polarität gesichert ist. Im Falle einer fehlerhaften Montage fallen die falsch montierten Bauteile sofort auf, da sie eine veränderte und somit untypische Außensymmetrie aufweisen.

Die Erfindung sowie die vorteilhaften Ausgestaltungen werden nachfolgend anhand einiger in den Zeichnungen dargestellter Ausführungsbeispiele näher erläutert.

In den Zeichnungen zeigen:
- Figur 1: eine schematische Seitenansicht einer Abwandlung einer Anordnung mit einem optoelektronischen Bauelement montiert auf einem weiteren Bauteil mit einer dazwischen liegenden Kontaktfläche und einem Steg,
- Figur 2: eine schematische Seitenansicht einer Abwandlung einer Anordnung mit einem optoelektronischen Bauelement montiert auf einem weiteren Bauteil mit zwei Kontaktbereichen und dazwischen liegendem Steg,
- Figur 3: schematisch der Steg mit aufgerauter Seitenfläche,
- Figur 4: schematisch der Steg mit aufgerauter Stirnfläche,
- Figur 5: eine erfindungsgemäße Anordnung mit Einführschrägen am Steg sowie an den Kontakten,
- Figur 6: in schematischer Seitenansicht eine Abwandlung einer Anordnung mit einem optoelektronischen Bauelement montiert auf einem weiteren Bauteil mit zwei Stegen am optoelektronischen Bauelement und einem dazwischen angeordneten Steg am weiteren Bauteil,
- Figur 7: in schematischer Seitenansicht eine Abwandlung einer Anordnung mit einem Stapel von zwei optoelektronischen Bauelementen montiert auf einem Submount mit jeweils zwischen den Kontaktbereichen angeordneten Stegen und
- Figur 8: eine Abwandlung, gemäß welcher das optoelektronische Bauelement mit den Kontakten und dem Steg gegenüberliegend vom weiteren Bauelement angeordnet ist.

Elemente gleicher Funktion sind nachfolgend figurenübergreifend mit den gleichen Bezugszeichen versehen.

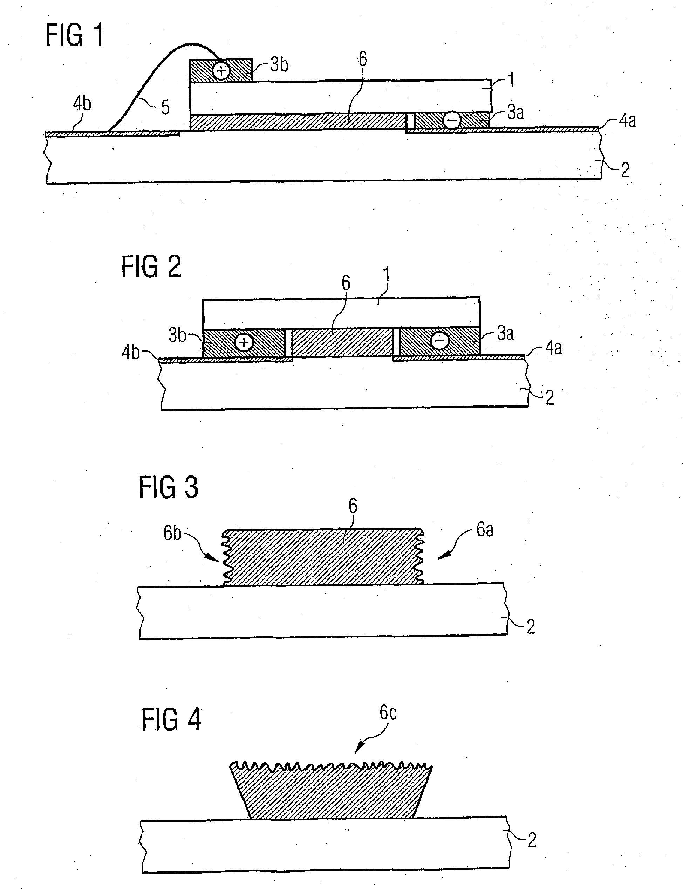

Figur 1 zeigt eine schematische Seitenansicht, ein optoelektronisches Bauelement 1, welches mit einem weiteren Bauteil 2 verbunden ist. Das optoelektronische Bauelement ist in der Regel als strahlungsemittierendes Bauelement ausgebildet, welches gemäß Figur 1 die Strahlung nach oben abstrahlt.

Die Ausbildung kann substratlos zum Beispiel als monolithische Diode oder durch die Anordnung eines Halbleiterchips auf einem Trägerkörper gewählt sein.

In der Abwandlung gemäß Figur 1 weist das optoelektronische Bauelement zwei Kontakte 3a, 3b auf, wobei ein Kontakt 3a zwischen dem optoelektronischen Bauelement 1 und dem weiteren Bauteil 2 angeordnet ist, sodass dieser Kontakt 3a einen Kontakt 4a an dem weiteren Bauteil 2 kontaktiert.

Der weitere Kontakt 3b des optoelektronischen Bauelementes 1 ist an der Oberseite angeordnet und mit einem weiteren Kontakt 4b des weiteren Bauteiles 2 über einen Bonddraht 5 verbunden.

In dem Bereich zwischen dem optoelektronischen Bauelement 1 und dem weiteren Bauteil 2, welcher nicht für die Kontaktierung der Kontakte 3a, 4a verwendet wird, ist ein Steg 6 angeordnet, welcher in der Höhe so ausgestaltet ist, dass er die Höhe des Kontaktes 3a am optoelektronischen Bauelement 1 überbrückt. Der Steg 6 dient zum einen zur Festlegung der Montageposition zwischen dem optoelektronischen Bauelement 1 und dem weiteren Bauteil 6 sowie auch zur verbesserten Wärmeleitung vom optoelektronischen Bauelement 1 in das weitere Bauteil 2.

Das weitere Bauteil 2 kann eine Unterlage, wie ein Submount oder auch ein weiteres Bauelement insbesondere auch ein weiteres optoelektronisches Bauelement sein.

Der Steg 6 muss nicht einstückig ausgebildet sein, sondern kann auch aus mehreren Teilstegen aufgebaut sein und kann auch im Bereich zum Kontakt 3a abgeschrägt sein, um hier eine Einführschräge (gestrichelt eingezeichnet) für die Montage zu erzielen.

Figur 2 zeigt eine ähnliche Abwandlung wie Figur 1, wobei beide Kontakte 3a und 3b des optoelektronischen Bauelementes 1 auf der Unterseite, das heißt im Bereich zwischen dem optoelektronischen Bauelement 1 und dem weiteren Bauteil 2 angeordnet sind.

Diese Ausbildung des optoelektronischen Bauelements 1 findet sich insbesondere bei Flipchip-Bauelementen, zum Beispiel einer monolithischen Diode im Chip Scale Package (CSP) wieder.

Der Steg 6 ist hier zwischen den beiden Kontakten 3a und 3b angeordnet, und legt somit noch eindeutiger die Montageposition zwischen dem optoelektronischen Bauelement und dem weiteren Bauteil 2 fest. Der Steg 6 muss nicht zwangsläufig am weiteren Bauteil 2 angeordnet sein, sondern kann ebenso auch am optoelektronischen Bauelement 1 befestigt sein.

Die Kontaktierung zwischen den Kontakten 3a, 4a beziehungsweise 3b, 4b erfolgt wie herkömmlich über Lot oder leitfähigen Kleber.

Durch die Anordnung des Steges 6 zwischen den Kontaktbereichen 3a, 4a und 3b, 4b dient der Steg 6 auch zur Kurzschlussvermeidung, da bei der Montage ein Fließen des Lotes auch von dem Kontaktbereich 3a, 4a zum Kontaktbereich 3b, 4b vermieden wird. Auch über längere Zeit wird ein Kriechen des Lotes von dem einen Kontaktbereich zu dem anderen über den Steg 6 erheblich erschwert oder komplett vermieden.

Figur 3 zeigt den Steg 6 mit wellig ausgebildeten seitlichen Flanken 6a und 6b. Diese welligen seitlichen Flanken beziehungsweise Seitenflächen verhindern zusätzlich ein Kriechen des Lotes über die Lebensdauer eines derartigen Bauelementes und tragen somit zur Kriechstromvermeidung bei. Diese welligen Seitenflächen lassen sich durch stehende Wellen und die Wahl geeigneter Fotolackdicken erzeugen.

Darüber hinaus wird durch diese wellige Oberfläche ein besserer mechanischer Kontakt erzielt, wodurch auch die Wärmeleitung vom optoelektronischen Bauelement 1 über die Kontaktbereiche 3a, 3b in den Steg 6 erhöht wird.

Figur 4 zeigt hierzu ebenfalls isoliert den Steg 6 auf dem weiteren Bauelement 2, wobei der Steg 6 an seiner Oberfläche 6c zur Erzielung eines besseren mechanischen Kontaktes und somit zur Erzielung einer besseren Wärmeleitung aufgeraut ist. Die Herstellung einer aufgerauten Oberfläche 6c, wie sie in Figur 4 dargestellt ist, kann zum Beispiel durch Schleifen erzeugt werden. Die Wärmeleitung kann durch Wärmeleitpasten oder Füller gesteigert werden.

Die aufgeraute Oberfläche 6c in Verbindung mit der Wärmeleitpaste hat den Vorteil eines idealen thermischen Kontaktes bei dem gleichzeitigen Vorteil, dass die Gefahr vermieden wird, dass bei der Herstellung des Kontaktes in den Kontaktbereichen 3a, 4a beziehungsweise 3b, 4b mechanischer Stress über den Steg 6 in das optoelektronische Bauelement 1 eingebracht wird.

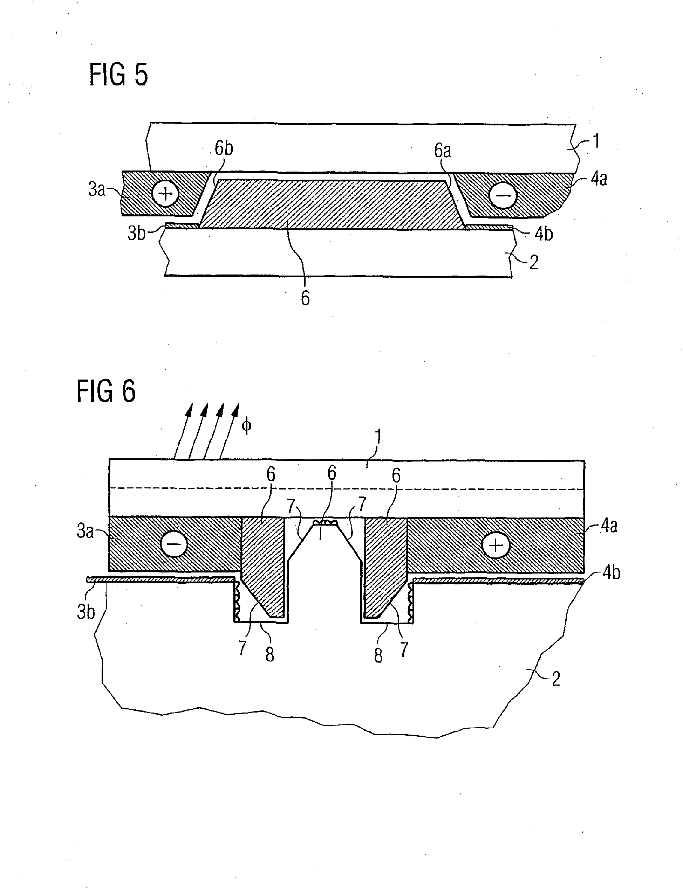

Figur 5 zeigt eine erfindungsgemäße Ausführungsform, wobei der Steg 6 an den Seitenflanken 6a und 6b abgeschrägt ist und die Kontakte 4a, 4b an den gegenüberliegenden Flanken ebenso abgeschrägt ausgebildet sind. Durch diese Ausführungsform ergibt sich eine besonders gute Selbstjustage. Bei zum Beispiel 50 bis 70 µm breiten Kontaktflanken 3a und 4a und einer Breite des Steges 6 < 100 µm kann Standardequipment für die Herstellung verwendet werden. Bei der Verwendung von Spezialequipment sind extrem schmale Kontaktzwischenräume, das heißt extrem schmale Stege 6 mit entsprechend größerer Kontaktfläche in den Kontaktbereichen 3a, 3b und 4a, 4b und somit auch ein gesteigerter Wärmeübergang realisierbar.

Figur 6 zeigt eine Abwandlung mit drei Stegen 6, wobei zwei Stege am optoelektronischen Bauelement 1 und der mittlere Steg 6 am weiteren Bauteil 2 in diesem Fall einem Submount ausgebildet ist.

Das optoelektronische Bauelement 1 ist in diesem Fall als eine nach oben in Pfeilrichtung Licht emittierende Leuchtdiode ausgebildet.

Die Stege 6 am optoelektronischen Bauelement 1 sind seitlich der Kontakte 3a und 4a ausgebildet und dienen sowohl zur Isolierung als auch Zentrierung. In dieser Abwandlung sind die am optoelektronischen Bauelement 1 angeordneten Stege 6 über die Unterseite der Kontaktflächen 3a und 4a überstehend ausgebildet. Das Submount bzw., das weitere Bauteil 2 weist in diesem Bereich entsprechende Aussparungen 8 auf, in welche der überspringende Teil der Stege 6 eingreift. Zur Zentrierung weisen diese Stege an den Außenseiten Einführschrägen 7 auf, durch welche eine exakte Selbstjustage bei der Montage erzielt wird. Der mittlere Steg 6, welcher am Submount 2 festgelegt ist, weist ebenso an den oberen Seitenkanten jeweils Einführschrägen 7 auf, sodass auch die beiden äußeren Stege 6, welche mit dem optoelektronischen Bauelement 1 verbunden sind, über diese Einführschrägen 7 exakt geführt werden.

Zur Kriechstromvermeidung sind in der Aussparung 8 die Seitenwandungen unterhalb der Kontakte 3a und 4a wellig ausgeführt.

Ebenso ist die Oberfläche des mittleren Steges 6, welcher direkt mit dem Submount oder dem weiteren Bauteil 2 verbunden ist, aufgeraut ausgeführt, um im montierten Zustand auch hier einen optimalen Wärmeübergang zwischen optoelektronischem Bauelement 1 und dem mittleren Steg 6 zu erzielen.

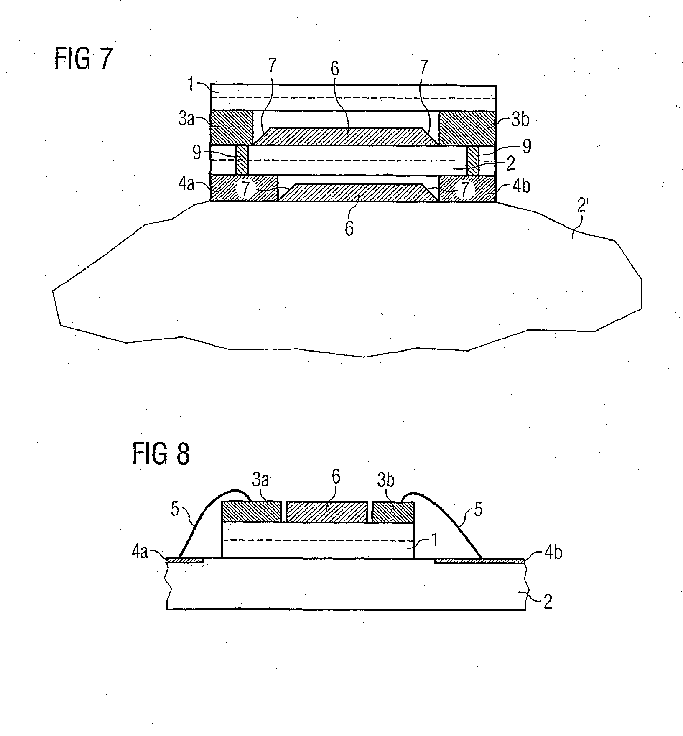

Figur 7 zeigt eine weitere Abwandlung der Erfindung, wobei hier zwei optoelektronische Bauelemente übereinander gestapelt sind.

Das weitere Bauteil 2 ist somit ebenfalls als optoelektronisches Bauelement ausgeführt und der Steg 6 ist an der Oberseite des weiteren optoelektronischen Bauelements 2 angeordnet, um das obere optoelektronische Bauelement 1 über die Kontakte 3a und 3b mechanisch zentriert aufzunehmen und auch eine Kurzschlussvermeidung zwischen den beiden Kontakten 3a und 3b zu erzielen.

Die beiden optoelektronischen Bauelemente 1 und 2 sind durch so genannte Vias 9, das heißt Durchgangsbohrungen, welche mit Lot gefüllt sind, miteinander kontaktiert.

Sowohl am oberen Steg 6 wie auch im unteren Steg 6 sind seitlich die Flanken abgeschrägt und dadurch Einführschrägen 7 gebildet.

Das weitere optoelektronische Bauelement 2 ist funktional passend mit dem darunter angeordneten Submount 2' kontaktiert. Diese Kontaktierung ist nicht näher dargestellt und kann zum Beispiel durch eine isolierte Durchkontaktierung oder T-Kontakt oder mittels CPHF (CPHF = compact planar high flux) -Technologie oder sonstiger passender Verbindungen realisiert sein.

Das optoelektronische Bauelement 1 und das optoelektronische Bauelement 2, welches hier das weitere Bauteil darstellt, sind zum Beispiel jeweils eine blaue und gelbe Leuchtdiode oder ein Sender-Detektorpaar zur Funktionskontrolle des Senders.

Besonders günstig kann zum Beispiel folgende Realisierung sein. Der Submount 2' ist als so genannter Modulsubmount CPHF-Technologie ausgebildet. Das darüber angeordnete Bauelement 2 ist als stabiler blauer durchkontaktierte CSP-LED mit integriertem frontseitigen durchsichtigen Steg sowie Kontakten an der Oberseite ausgebildet. Darüber ist das Bauelement 1 angeordnet, eine wenige µm dicke für blaues Licht durchsichtige substratlose gelbe Diode, welche durchkontaktiert oder eventuell mittels konventionellem Wirebonding kontaktiert ist.

In Summe ergibt sich durch die erfindungsgemäße Ausbildung des Steges eine Vielzahl von Vorteilen. Die Wärmeleitung wird verbessert, die Kurzschlussgefahr reduziert, Selbstjustage bei der Montage und erhöhte Stabilität. Durch diese Vorteile lässt sich eine geringere Baugröße der Anordnung erzielen.

Durch die transparente Ausbildung der Stege lassen sich viele neue Anwendungsformen realisieren und durch die seitliche Ausbildung von Einführschrägen an den Stegen ist die Verbindung bei übereinander gestapelten Bauelementen wesentlich einfacher realisierbar.

Die Ausbildung der Stege zwischen den Kontaktbereichen steigert auch die ESD-Verträglichkeit, da scharfe Kanten und spitze Bauformen vermieden werden.

Durch die Verwendung von normalerweise von der Wärmeausdehnung her nicht passender Materialien im Stegbereich kann eine höhere Wärmeabfuhr und somit eine Leistungssteigerung der gesamten Anordnung erzielt werden. Die gesteigerte Wärmeabfuhr senkt die Betriebstemperatur, wodurch noch kleinere Bauformen realisierbar sind. Des Weiteren ergeben sich auch Einsparungen bei ansonsten nötigen zusätzlichen Wärmesenken. Durch die Selbstjustage und Zentrieren können beim Aufbau beziehungsweise bei der Herstellung kostengünstigere schnellere und nicht so präzise arbeitende Automaten verwendet werden.

Figur 8 zeigt eine weitere Abwandlung der Erfindung, wobei hier das optoelektronische Bauelement 1 so auf ein weiteres Bauelement 2 montiert ist, dass die Kontakte 3a und 3b nach oben zeigen. Die Kontakte 3a und 3b sind über einen herkömmlichen Bonddraht mit weiteren Kontakten 4a und 4b des weiteren Bauteiles 2 kontaktiert. Der Steg 6 zwischen den Kontakten 3a und 3b dient hier zum einen der besseren Wärmeabführung und zum anderen der Kurzschlussvermeidung bei der Kontaktierung der Bonddrähte 5 sowie auch der Kurzschlussvermeidung aufgrund der Kriecheigenschaften des Lotes.

Diese Abwandlung eignet sich insbesondere für die Verwendung bei der Beleuchtung der Außenfassade von Häusern oder anderen Objekten im Freien, bei welchem der Betrachter das optoelektronische Bauelement nur von der Ferne sieht. Die Lichtemission des optoelektronischen Bauelementes kann entweder durch den transparent ausgebildeten Steg 6 oder auch seitlich erfolgen.

## Patentansprüche

1. Anordnung umfassend ein optoelektronisches Bauelement (1) mit zwei Kontakten (3a, 3b) und wenigstens einem weiteren Bauteil (2), wobei zumindest ein Kontakt zwischen dem optoelektronischen Bauelement (1) und dem weiteren Bauteil (2) angeordnet ist,
wobei zwischen dem optoelektronischen Bauelement (1) und dem weiteren Bauteil (2) zumindest ein Steg (6) angeordnet ist,
**dadurch gekennzeichnet, dass**
an dem Steg (6) sowie an dem Kontakt zwischen dem optoelektronischen Bauelement (1) und dem weiteren Bauteil (2) Einführschrägen (7) ausgebildet sind und die Einführschrägen so in Wirkung treten, dass bei der Montage eine Selbstjustage zwischen dem optoelektronischen Bauelement (1) und dem weiteren Bauteil (2) erfolgt.

2. Anordnung nach Anspruch 1,
**dadurch gekennzeichnet, dass**
der Steg (6) unmittelbar neben dem Kontakt (3a) angeordnet ist und den Bereich neben dem Kontakt (3a) zwischen dem optoelektronischen Bauelement (1) und dem weiteren Bauteil (2) überbrückt.

3. Anordnung nach Anspruch 1,
**dadurch gekennzeichnet, dass**
beide Kontakte (3a, 3b) zwischen dem optoelektronischen Bauelement (1) und dem weiteren Bauteil (2) angeordnet sind und der Steg (6) zwischen den Kontakten (3a, 3b) des optoelektronischen Bauelementes (1) angeordnet ist.

4. Anordnung nach einem der Ansprüche 1 bis 3,
**dadurch gekennzeichnet, dass**
der Steg (6) an dem optoelektronischen Bauelement (1) oder an dem weiteren Bauteil (2) oder mehrere Stege (6) kombiniert am optoelektronischen Bauelement (1) und dem weiteren Bauteil (2) angeordnet sind.

5. Anordnung nach einem der Ansprüche 1 bis 4,
**dadurch gekennzeichnet, dass**
das weitere Bauteil (2) ein Submount oder ein weiteres optoelektronisches Bauelement ist.

6. Anordnung nach einem der Ansprüche 1 bis 5,
**dadurch gekennzeichnet, dass**
der Steg (6) aus einem der folgenden Materialien oder einer Kombination der vorgenannten Materialien hergestellt ist: Molybdän, Tantal, Aluminium, Aluminiumnitrid, Kupfer, Legierungen, Titannitrid passiviert, Wolframnitrid und Titan-Wolframnitrid, Gold, Silber, passivierte elektrische Leiter, Dielektrika, Diamant, diamantartige Stoffe, Kunststoffe oder elektrisch isolierendes transparentes Material.

7. Anordnung nach einem der Ansprüche 1 bis 6,
**dadurch gekennzeichnet, dass**
zwischen dem optoelektronischen Bauelement (1) und dem weiteren Bauteil (2) ein freier Bereich ohne direkten Kontakt besteht.

8. Anordnung nach einem der Ansprüche 1 bis 7,
**dadurch gekennzeichnet, dass**
zwei oder mehrere optoelektronische Bauelemente (1,2) übereinander gestapelt sind.

9. Anordnung nach Anspruch 8,
**dadurch gekennzeichnet, dass**
die optoelektronischen Bauelemente (1,2) deckungsgleich oder größenmäßig unterschiedlich sind.

10. Anordnung nach einem der Ansprüche 8 oder 9,
**dadurch gekennzeichnet, dass**
die optoelektronischen Bauelemente (1, 2) durch Durchkontaktierungen (9) miteinander kontaktiert sind.

11. Anordnung nach einem der Ansprüche 1 bis 10,
**dadurch gekennzeichnet, dass**
der Steg (6) unsymmetrisch ausgeführt ist, sodass eine Codierung entsteht und die Polarität bei der Montage gesichert ist.

## Claims

1. Arrangement comprising an optoelectronic component (1) with two contacts (3a, 3b) and at least one further component part (2), wherein at least one contact is arranged between the octoelectronic component (1) and the further component part (2),
wherein at least one web (6) is arranged between the optoelectronic component (1) and the further component part (2),
**characterized in that**
insertion bevels (7) are formed at the web (6) and at the contact between the optoelectronic component (1) and the further component part (2) and the insertion bevels take effect in such a way that self-alignment between the optoelectronic component (1) and the further component part (2) is effected during mounting.

2. Arrangement according to Claim 1,
**characterized in that**
the web (6) is arranged directly alongside the contact (3a) and bridges the region alongside the contact (3a) between the optoelectronic component (1) and the further component part (2).

3. Arrangement according to Claim 1,
**characterized in that**
both contacts (3a, 3b) are arranged between the optoelectronic component (1) and the further component part (2) and the web (6) is arranged between the contacts (3a, 3b) of the optoelectronic component (1).

4. Arrangement according to any of Claims 1 to 3,
**characterized in that**
the web (6) is arranged at the optoelectronic component (1) or at the further component part (2) or a plurality of webs (6) are arranged in combined fashion at the optoelectronic component (1) and the further component part (2).

5. Arrangement according to any of Claims 1 to 4,
**characterized in that**
the further component part (2) is a submount or a further optoelectronic component.

6. Arrangement according to any of Claims 1 to 5,
**characterized in that**
the web (6) is produced from one of the following materials or a combination of the aforementioned materials: molybdenum, tantalum, aluminium, aluminium nitride, copper, alloys, titanium nitride passivated, tungsten nitride and titanium-tungsten nitride, gold, silver, passivated electrical conductors, dielectrics, diamond, diamond-like substances, plastics or electrically insulating transparent material.

7. Arrangement according to any of Claims 1 to 6,
**characterized in that**
there is a free region without direct contact between the optoelectronic component (1) and the further component part (2).

8. Arrangement according to any of claims 1 to 7,
**characterized in that**
two or more optoelectronic components (1, 2) are stacked one above another.

9. Arrangement according to Claim 8,
**characterized in that**
the optoelectronic components (1, 2) are congruent or different in size.

10. Arrangement according to either of Claims 8 and 9,
**characterized in that**
the optoelectronic components (1, 2) are contact-connected to one another by plated-through holes (9).

11. Arrangement according to any of Claims 1 to 10,
**characterized in that**
the web (6) is embodied asymmetrically, such that a coding arises and the polarity is safeguarded during mounting.

## Revendications

1. Ensemble comprenant un composant optoélectronique (1) avec deux contacts (3a, 3b) et au moins un composant supplémentaire (2), au moins un contact étant disposé entre le composant optoélectronique (1) et le composant supplémentaire (2) ;
au moins un étai (6) étant disposé entre le composant optoélectronique (1) et le composant supplémentaire (2) ;
**caractérisé en ce que** :
des biseaux d'introduction (7) sont réalisés entre le composant optoélectronique (1) et le composant supplémentaire (2) au niveau de l'étai (6) ainsi qu'au niveau du contact et que les biseaux d'introduction agissent de telle sorte qu'un auto-ajustement se produit entre le composant optoélectronique (1) et le composant supplémentaire (2) lors du montage.

2. Ensemble selon la revendication 1, **caractérisé en ce que** l'étai (6) est disposé directement à côté du contact (3a) et chevauche la zone placée à côté du contact (3a) entre le composant optoélectronique (1) et le composant supplémentaire (2).

3. Ensemble selon la revendication 1, **caractérisé en ce que** les deux contacts (3a, 3b) sont disposés entre le composant optoélectronique (1) et le composant supplémentaire (2) et que l'étai (6) est disposé entre les contacts (3a, 3b) du composant optoélectronique (1).

4. Ensemble selon l'une quelconque des revendications 1 à 3, **caractérisé en ce que** l'étai (6) est disposé au niveau du composant optoélectronique (1) ou au niveau du composant supplémentaire (2) ou que plusieurs étais (6) sont disposés de façon combinée au niveau du composant optoélectronique (1) et du composant supplémentaire (2).

5. Ensemble selon l'une quelconque des revendications 1 à 4, **caractérisé en ce que** le composant supplémentaire (2) est une embase ou un autre composant optoélectronique.

6. Ensemble selon l'une quelconque des revendications 1 à 5, **caractérisé en ce que** l'étai (6) est fabriqué à partir d'un des matériaux suivants ou d'une combinaison des matériaux susmentionnés : molybdène, tantale, aluminium, nitrure d'aluminium, cuivre, alliages, nitrure de titane rendu passif, nitrure de wolfram et nitrure de titane-wolfram, or, argent, conducteur électrique rendu passif, diélectriques, diamant, substance de type diamant, matières plastiques ou matière transparente électriquement isolante.

7. Ensemble selon l'une quelconque des revendications 1 à 6, **caractérisé en ce qu'**une zone libre sans contact direct subsiste entre le composant optoélectronique (1) et le composant supplémentaire (2).

8. Ensemble selon l'une quelconque des revendications 1 à 7, **caractérisé en ce que** deux composants optoélectroniques (1, 2) ou plus sont empilés les uns sur les autres.

9. Ensemble selon la revendication 8, **caractérisé en ce que** les composants optoélectroniques (1, 2) sont identiques en terme de revêtement ou de dimensions différentes.

10. Ensemble selon l'une quelconque des revendications 8 ou 9, **caractérisé en ce que** les composants optoélectroniques (1, 2) sont mis au contact les uns des autres par le biais de contacts traversants (9).

11. Ensemble selon l'une quelconque des revendications 1 à 10, **caractérisé en ce que** l'étai (6) est réalisé de façon asymétrique, de sorte qu'un codage se produise et que la polarité soit assurée lors du montage.
